# FASCICULE DE BREVET EUROPEEN

(11) **EP 2 870 638 B1**
(45) Date de publication et mention de la délivrance du brevet: **13.01.2016**
(21) Numéro de dépôt: 13756534.7
(22) Date de dépôt: 04.07.2013
(51) Int. Cl.: G09F 13/14, H02S 40/22, H01L 31/048

(54) **DISPOSITIF POUR AMÉLIORER LA QUALITÉ D'UNE IMAGE RECOUVERTE D'UN FILM PHOTOVOLTAÏQUE SEMI-TRANSPARENT**
VORRICHTUNG ZUR VERBESSERUNG DER QUALITÄT EINES MIT EINER HALBTRANSPARENTEN FOTOVOLTAISCHEN FILMBESCHICHTUNG ABGEDECKTEN BILDES
DEVICE FOR IMPROVING THE QUALITY OF AN IMAGE COVERED BY A SEMI-TRANSPARENT PHOTOVOLTAIC FILM

(30) Priorité: 06.07.2012 FR 1201927
(43) Date de publication de la demande: 13.05.2015
(73) Titulaire: Sunpartner Technologies, 13090 Aix-en-Provence (FR)
(72) Inventeur: GILBERT, Joël, F-13510 Eguilles (FR)
(74) Mandataire: Nicolle, Olivier
(86) Numéro de dépôt international: PCT/FR2013/000174
(87) Numéro de publication internationale: WO 2014/006282

(56) Documents cités:
- WO-A1-2005/071760
- FR-A1- 2 896 596
- JP-A- H11 296 636
- JP-A- 2008 072 004

## Description

La présente invention se rapporte au domaine des images qui sont recouvertes par une plaque photovoltaïque semi-transparente.

### ETAT DE LA TECHNIQUE

Les dispositifs qui permettent de produire de l'électricité photovoltaïque à la surface d'une image utilisent en général une plaque photovoltaïque semi-transparente posée ou collée à la surface de l'image.

Cette plaque photovoltaïque est constituée d'une plaque transparente sur laquelle ont été déposées des bandes photovoltaïques parallèles de faibles largeurs séparées par une distance qui est fonction de la transparence que l'on souhaite obtenir. Ainsi, plus cette distance est importante et plus le taux de couverture de la couche photovoltaïque est faible et donc plus la transparence est importance. A contrario, plus la distance entre les bandes photovoltaïques est petite et plus le taux de couverture est important ce qui entraine une transparence plus faible. Plus la transparence est faible et plus l'image perd en luminosité.

La production d'électricité qui est générée par la plaque étant proportionnelle à la surface photovoltaïque, on a tout intérêt à augmenter cette surface sans toutefois dépasser un seuil qui est fonction de la dégradation admissible de la luminosité de l'image. Ce compromis entre une recherche de production électrique maximale et une diminution minimale de la luminosité de l'image est subjectif puisqu'il dépend des caractéristiques de l'image, de la luminosité ambiante et de la perception visuelle de l'observateur.

On sait démontrer qu'il y a un minimum de perte de luminosité lorsque les couches photovoltaïques sont au plus proche de l'image, donc sans espace entre l'image et les couches opaques photovoltaïques. Mais certaines configurations imposent qu'il y ait une distance entre l'image et la plaque photovoltaïque, comme c'est le cas avec des affichages publicitaires rotatifs dans lesquels les images sont mobiles par rapport à la plaque vitrée et doivent donc rester distantes de la plaque pour éviter une attirance électrostatique et une usure prématurée à cause des frottements.

On connait aussi des dispositifs qui associent des bandes photovoltaïques à plusieurs images imbriquées afin de créer un effet optique d'image en relief par la technique dite de la barrière de parallaxe. Dans ces différents cas les images peuvent être de toute nature, y compris des images électroniques. Les couches photovoltaïques peuvent être aussi de toute nature, en silicium cristallin ou amorphe, ou être constituées par des multi-couches photosensibles comme du CIGS.

Le document WO 2005/071760 A propose une structure présentant une image recouverte d'une plaque photovoltaïque.

### BUT DE L'INVENTION

La disposition d'une plaque semi transparente sur une image provoque une diminution de sa luminosité. En effet la quantité de lumière qui éclaire l'image est diminuée par les bandes photovoltaïques qui font obstacle et qui absorbent une partie de la lumière incidente. Lorsque l'image et la plaque photovoltaïque sont distantes l'une de l'autre, donc non collées entre elles, une partie de la lumière qui est émise par l'image est elle-même stoppée par les cellules photovoltaïques, ce qui diminue encore la luminosité apparente de l'image.

Le but de l'invention est de réduire l'effet d'ombrage des cellules photovoltaïques tout en conservant la même surface photovoltaïque, ce qui va permettre de conserver la même puissance électrique et augmenter la luminosité de l'image donc sa qualité visuelle.

Grâce à l'invention on pourra aussi, d'une autre manière, augmenter la surface des cellules photovoltaïques tout en conservant la même luminosité, donc la qualité visuelle de l'image.

### RESUME DE L'INVENTION

Le terme « plaque photovoltaïque » inclut également les « films photovoltaïques » qui sont des plaques photovoltaïques de faibles épaisseurs et souples.

Le terme « image » inclus toutes images imprimées sur tout support et les images électroniques qui n'utilisent que la lumière ambiante, ainsi que la surface de tout « objet », cette surface constituant une image qui peut être de forme quelconque.

Le dispositif objet de l'invention est constitué d'une image sur laquelle est positionnée une plaque photovoltaïque semi transparente. L'image peut être une image imprimée ou une image électronique par exemple de type LCD, ou encore une image constituée de pixels rétro-éclairées par des miroirs, ou encore la surface colorée d'un objet quelconque, plat ou non plat, comme un mur, une tuile ou une table.

La plaque photovoltaïque semi transparente est une plaque transparente, en verre cristallin ou en verre organique, rigide ou souple, plane ou courbe, sur laquelle ont été déposées des cellules photovoltaïques cristallines ou amorphes, comme par exemple du silicium, ou encore un empilement de couches minces photosensibles et photovoltaïques comme par exemple du CIGS, ou encore des cellules organiques. Ces cellules peuvent être opaques ou semi-transparentes. Elles se répartissent à la surface de la plaque transparente pour former des zones opaques séparées par des zones de transparence, ou bien elles se répartissent sous forme de réseaux de figures géométriques comme par exemple des bandes rectilignes et parallèles séparées par des bandes de transparence.

Les cellules photovoltaïques possèdent deux faces dont l'une est tournée vers l'image ou vers l'objet. Cette face tournée vers l'image ou vers l'objet est recouverte d'une couche très réfléchissante à la lumière, comme par exemple une encre ou une peinture blanche ou un dépôt métallique d'aluminium ou de chrome à effet miroir. Par exemple, les faces des cellules photovoltaïques tournées vers l'image sont aptes à réfléchir plus de 30 % de la lumière qu'elles reçoivent. Cette face réfléchissante est séparée de l'image ou de la surface de l'objet par une distance non nulle. L'espace ainsi créé entre la face réfléchissante des cellules photovoltaïques et l'image peut être de l'air ou bien un matériau transparent comme du verre cristallin ou du verre organique.

L'image et la plaque qui la recouvre sont éclairées par une lumière incidente dont une partie est interceptée par les cellules photovoltaïques et dont une autre partie traverse les zones de transparence et éclaire l'image. Chaque pixel de l'image diffuse alors cette lumière dans toutes les directions. Cette lumière diffusée par l'image, soit traverse de nouveau les zones de transparence jusqu'à l'observateur, soit est réfléchie par les faces réfléchissantes des cellules photovoltaïques, soit est réfléchie au niveau des zones de transparence lorsque deux conditions sont remplies: l'indice de réfraction de l'espace entre les cellules et l'image est supérieur à l'air, et l'angle d'incidence du rayon lumineux est supérieur à l'angle critique de la réflexion totale au passage d'un dioptre à indice fort vers un indice faible.

Dans les cas où la lumière diffusée par l'image est réfléchie, celle-ci est réfléchie de nouveau vers l'image qui va de nouveau la diffuser. Le résultat est que la lumière diffusée par l'image qui sortira de la plaque vers l'observateur sera supérieure en intensité à ce qu'elle aurait été si les faces internes des cellules n'avaient pas été réfléchissantes. Pour l'observateur il verra donc une image plus lumineuse que si les faces internes des cellules étaient restées absorbantes ou non réfléchissantes.

Dans un mode de réalisation particulier de l'invention, et toujours afin d'augmenter la luminosité émise par l'image et compenser la perte de lumière absorbée par les cellules photovoltaïques, le dispositif est associé à des moyens pour modifier l'image d'origine notamment dans ses caractéristiques de brillance, de contraste et de saturation des couleurs. En effet l'image reçoit moins de lumière car une partie de celle-ci est arrêtée par les cellules photovoltaïques. L'observateur verra donc une image plus sombre, moins brillante, que celle d'origine. Pour corriger en partie cet inconvénient, l'image numérique d'origine subit un traitement informatique qui consiste à augmenter la luminosité de tout ou partie de ses pixels. Le pourcentage de cette augmentation de luminosité sera fonction des caractéristiques de l'image d'origine et du pourcentage d'ombrage des cellules photovoltaïques. En particulier, les moyens pour modifier la luminosité de l'image sont réglés pour augmenter la luminosité de l'image d'un pourcentage égal ou supérieur au pourcentage de couverture des cellules photovoltaïques sur la plaque.

Il en sera de même pour le contraste et la saturation des couleurs qui seront modifiés afin que la vision de l'observateur se rapproche le plus de la vision de l'image d'origine. Ainsi l'image recouverte de la plaque photovoltaïque produira de l'électricité avec un minimum de dégradation visuelle.

### DECRIPTION DETAILLEE DE L'INVENTION

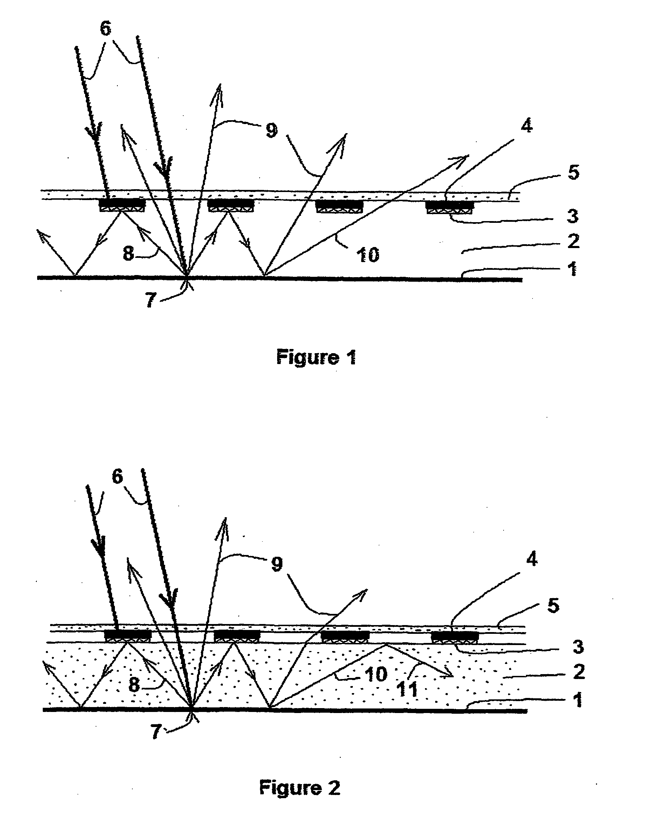

L'invention est maintenant décrite plus en détails à l'aide de la description des figures 1 et 2 indexées.
La figure 1 est un schéma de principe en coupe du dispositif selon l'invention.
La figure 2 est un schéma de principe en coupe d'une variante du dispositif avec un espace à fort indice de réfraction entre les cellules et l'image.

Le dispositif objet de l'invention (Figure 1) est constitué d'une image (7) sur laquelle est positionnée une plaque photovoltaïque semi transparente. L'image (7) peut être une image imprimée ou une image électronique par exemple de type LCD, ou encore une image constituée de pixels rétro-éclairées par des miroirs, ou encore la surface colorée d'un objet quelconque, plat ou non plat, comme un mur, une tuile ou une table.

La plaque photovoltaïque semi transparente est une plaque transparente (5), en verre cristallin ou en verre organique, rigide ou souple, plane ou courbe, sur laquelle ont été déposées des cellules photovoltaïques (4) cristallines ou amorphes, comme par exemple du silicium, ou encore un empilement de couches minces photosensibles comme par exemple du CIGS, ou encore des cellules organiques. Ces cellules (4) peuvent être opaques ou semi-transparentes. Elles se répartissent à la surface de la plaque transparente (5) pour former des zones opaques séparées par des zones de transparence, ou bien elles se répartissent sous forme de réseaux de figures géométriques comme par exemple des bandes rectilignes et parallèles séparées par des bandes de transparence.

Les cellules photovoltaïques (4) possèdent deux faces dont l'une est tournée vers l'image ou vers l'objet. Cette face tournée vers l'image ou vers l'objet est recouverte d'une couche (3) très réfléchissante à la lumière, comme par exemple une encre ou une peinture blanche ou un dépôt métallique d'aluminium ou de chrome à effet miroir. Cette face réfléchissante (3) est séparée de l'image (1) ou de la surface de l'objet (1) par une distance non nulle. L'espace (2) ainsi créé entre la face réfléchissante (3) des cellules photovoltaïques et l'image (1) peut être de l'air ou bien un matériau transparent (Figure 2) comme du verre cristallin ou du verre organique dont l'indice de réfraction est supérieur à 1.

L'image (1) et les cellules (4) qui la recouvrent sont éclairées par une lumière incidente (6) dont une partie est interceptée par les cellules photovoltaïques (4) et dont une autre partie traverse les zones de transparence et éclaire l'image (1). Chaque pixel (7) de l'image diffuse alors cette lumière dans toutes les directions (8,9,10). Cette lumière diffusée par l'image, soit traverse de nouveau les zones de transparence jusqu'à l'observateur (9), soit est réfléchie par les faces réfléchissantes (3) des cellules photovoltaïques (4), soit est réfléchie (10,11) au niveau des zones de transparence (Figure 2) lorsque deux conditions sont remplies: l'indice de réfraction de l'espace (2) entre les cellules (4) et l'image (1) est supérieur à l'air, et l'angle d'incidence du rayon lumineux (10 - Figure 2) est supérieur à l'angle critique de la réflexion totale au passage d'un dioptre à indice fort vers un indice faible.

Dans les cas où la lumière diffusée (10 - Figure 2) par l'image est réfléchie (11), celle-ci est réfléchie de nouveau vers l'image (1) qui va de nouveau la diffuser. Le résultat est que la lumière diffusée par l'image (1,7) qui sortira de la plaque vers l'observateur sera supérieure en intensité à ce qu'elle aurait été si les faces internes des cellules (4) n'avaient pas été réfléchissantes (3). L'observateur verra donc une image (1) plus lumineuse que si les faces internes des cellules (4) étaient absorbantes ou non réfléchissantes.

Dans un mode de réalisation particulier de l'invention, non illustré, et toujours afin d'augmenter la luminosité émise par l'image (1) et de compenser la perte de lumière absorbée par les cellules photovoltaïques (4), l'image d'origine (1) est modifiée notamment dans ses caractéristiques de brillance, de contraste et de saturation des couleurs. En effet l'image (1) reçoit moins de lumière car une partie de celle-ci est arrêtée par les cellules photovoltaïques (4). L'observateur verra donc une image plus sombre, moins brillante, que celle d'origine. Pour corriger en partie cet inconvénient, l'image numérique d'origine subit un traitement informatique qui consiste à augmenter la luminosité de tout ou partie de ses pixels. Le pourcentage de cette augmentation de luminosité sera fonction des caractéristiques de l'image d'origine et du pourcentage d'ombrage des cellules photovoltaïques. Il en sera de même pour le contraste et la saturation des couleurs qui seront modifiés afin que la vision de l'observateur se rapproche le plus de la vision de l'image d'origine. Ainsi l'image (1) recouverte de la plaque photovoltaïque (5) produira de l'électricité avec un minimum de dégradation visuelle.

On décrit maintenant un exemple concret de réalisation.

Le dispositif selon l'invention comprend une image (1) papier carrée d'un mètre de côtés et une plaque (5) de verre de mêmes dimensions et de 4 mm d'épaisseur sur laquelle a été déposé un réseau de bandes parallèles de couches minces photovoltaïques (4) en silicium amorphe dont la largeur est de 1 mm et la distance qui les sépare est de 3 mm.

Les bandes photovoltaïques (4) sont recouvertes sur une des faces (3) d'un dépôt en couche mince d'aluminium qui à la propriété de réfléchir plus de 60% de la lumière qu'il reçoit. Cette face (3) qui est recouverte d'une couche réfléchissante est tournée vers l'image (1) et la recouvre. La distance entre la plaque photovoltaïque et l'image est de 1 cm. Cet espace (2) ne contient que de l'air. Le taux de couverture du photovoltaïque à la surface de la plaque est de 25%. L'image numérique a été modifiée avant son impression papier (1) en augmentant sa luminosité de 30% et en diminuant son contraste de 5%. Ainsi l'observateur qui regarde l'image (1) au travers de la plaque photovoltaïque (5) verra une image qui n'aura perdu que très peu de sa luminosité d'origine. La plaque photovoltaïque (5) produira environs 15 Watts de puissance électrique en plein solaire tout en restituant une image très proche de celle d'origine.

### AVANTAGES DE L'INVENTION

En définitive l'invention répond aux buts fixés. Elle est particulièrement adaptée pour recouvrir une image ou un objet avec une plaque ou un film photovoltaïque semi-transparent tout en réduisant la dégradation visuelle de l'image.

## Revendications

1. Dispositif comprenant d'une part une image (1) et d'autre part une plaque photovoltaïque (5) disposée entre l'image et un observateur, cette plaque photovoltaïque étant constituée de zones de transparence lumineuse et de zones recouvertes de cellules photovoltaïques (4) dont une des deux faces (3) est orientée vers l'image (1), **caractérisé en ce que** lesdites faces (3) des cellules photovoltaïques (4) tournées vers l'image sont réfléchissantes de manière à réfléchir vers l'image (1) une partie de la lumière émise par ladite image et à augmenter sa luminosité vue par l'observateur au travers des zones de transparence, de manière à compenser l'effet d'ombrage induit par les cellules photovoltaïques.

2. Dispositif selon la revendication 1, **caractérisé en ce que** la plaque photovoltaïque (5) est disposée à une distance non nulle au-dessus de la surface de l'image (1).

3. Dispositif selon la revendication 1, **caractérisé en ce que** lesdites faces (3) des cellules photovoltaïques (4) tournées vers l'image sont aptes à réfléchir plus de 30% de la lumière qu'elles reçoivent.

4. Dispositif selon l'une quelconque des revendications précédentes, **caractérisé en ce que** lesdites faces (3) des cellules photovoltaïques (4) tournées vers l'image sont de couleur blanche ou d'aspect métallique.

5. Dispositif selon l'une quelconque des revendications précédentes, **caractérisé en ce que** la plaque photovoltaïque (5) est fine et/ou souple.

6. Dispositif selon l'une quelconque des revendications précédentes, **caractérisé en ce que** la plaque photovoltaïque (5) est en verre cristallin ou en verre organique.

7. Dispositif selon l'une quelconque des revendications précédentes, **caractérisé en ce que** les cellules photovoltaïques (4) sont en silicium cristallin et/ou amorphe ou organique ou constituées d'une pluralité de couches minces photovoltaïques.

8. Dispositif selon l'une quelconque des revendications précédentes, **caractérisé en ce que** les cellules photovoltaïques (4) forment un réseau de bandes parallèles entre elles et séparées par des bandes de transparence.

9. Dispositif selon l'une quelconque des revendications précédentes, **caractérisé en ce que** les cellules photovoltaïques (4) sont séparées de l'image (1) ou de l'objet par un espace (2) composé d'un matériau transparent dont l'indice de réfraction est supérieur à 1.

10. Dispositif selon l'une quelconque des revendications précédentes, **caractérisé en ce qu'**il comporte des moyens pour modifier la luminosité de l'image et/ou le contraste de l'image et/ou la saturation des couleurs de l'image (1) de manière à visuellement compenser la dégradation de l'image due à la superposition de la plaque photovoltaïque (5) au-dessus de l'image.

11. Dispositif selon la revendication 10, **caractérisé en ce que** lesdits moyens pour modifier la luminosité de l'image sont réglés pour augmenter la luminosité de l'image d'un pourcentage égal ou supérieur au pourcentage de couverture des cellules photovoltaïques (4) sur la plaque (5).

## Patentansprüche

1. Vorrichtung, die einerseits ein Bild (1) und andererseits eine Photovoltaikplatte (5) enthält, die zwischen dem Bild und einem Betrachter angeordnet ist, wobei diese Photovoltaikplatte aus Lichttransparenzzonen und mit Photovoltaikzellen (4) bedeckten Zonen besteht, von denen eine der zwei Seiten (3) zum Bild (1) gerichtet ist, **dadurch gekennzeichnet, dass** die zum Bild gerichteten Seiten (3) der Photovoltaikzellen (4) reflektierend sind, um einen Teil des vom Bild emittierten Lichts zum Bild (1) zu reflektieren und seine vom Betrachter durch die Transparenzzonen hindurch gesehene Helligkeit zu erhöhen, um die durch die Photovoltaikzellen hervorgerufene Schattierungswirkung zu kompensieren.

2. Vorrichtung nach Anspruch 1, **dadurch gekennzeichnet, dass** die Photovoltaikplatte (5) in einem Abstand ungleich Null über der Oberfläche des Bilds (1) angeordnet ist.

3. Vorrichtung nach Anspruch 1, **dadurch gekennzeichnet, dass** die zum Bild gerichteten Seiten (3) der Photovoltaikzellen (4) mehr als 30% des Lichts reflektieren können, das sie empfangen.

4. Vorrichtung nach einem der vorhergehenden Ansprüche, **dadurch gekennzeichnet, dass** die zum Bild gerichteten Seiten (3) der Photovoltaikzellen (4) von weißer Farbe oder von metallischen Aussehen sind.

5. Vorrichtung nach einem der vorhergehenden Ansprüche, **dadurch gekennzeichnet, dass** die Photovoltaikplatte (5) dünn und/oder biegsam ist.

6. Vorrichtung nach einem der vorhergehenden Ansprüche, **dadurch gekennzeichnet, dass** die Photovoltaikplatte (5) aus Kristallglas oder aus organischem Glas ist.

7. Vorrichtung nach einem der vorhergehenden Ansprüche, **dadurch gekennzeichnet, dass** die Photovoltaikzellen (4) aus kristallinem und/oder amorphem oder organischem Silicium sind oder aus einer Vielzahl dünner photovoltaischer Schichten bestehen.

8. Vorrichtung nach einem der vorhergehenden Ansprüche, **dadurch gekennzeichnet, dass** die Photovoltaikzellen (4) ein Netz von Streifen formen, die zueinander parallel und durch Transparenzstreifen getrennt sind.

9. Vorrichtung nach einem der vorhergehenden Ansprüche, **dadurch gekennzeichnet, dass** die Photovoltaikzellen (4) vom Bild (1) oder vom Gegenstand durch einen Raum (2) getrennt sind, der aus einem transparenten Material besteht, dessen Brechungsindex höher als 1 ist.

10. Vorrichtung nach einem der vorhergehenden Ansprüche, **dadurch gekennzeichnet, dass** sie Einrichtungen aufweist, um die Helligkeit des Bilds und/oder den Kontrast des Bilds und/oder die Sättigung der Farben des Bilds (1) so zu verändern, dass die Verschlechterung des Bilds aufgrund der Überlagerung der Photovoltaikplatte (5) über dem Bild visuell kompensiert wird.

11. Vorrichtung nach Anspruch 10, **dadurch gekennzeichnet, dass** die Einrichtungen zur Veränderung der Helligkeit des Bilds eingestellt werden, um die Helligkeit des Bilds um einen Prozentsatz zu erhöhen, der gleich dem oder höher als der Abdeckungsprozentsatz der Photovoltaikzellen (4) auf der Platte (5) ist.

## Claims

1. Device including, on the one hand, an image (1) and, on the other hand, a photovoltaic sheet (5) arranged between the image and an observer, this photovoltaic sheet being made up of luminous transparent areas and areas covered with photovoltaic cells (4), one of the two sides (3) of which is oriented toward the image (1), **characterized in that** said sides (3) of the photovoltaic cells (4) turned toward the image are reflective in such a way as to reflect, toward the image (1), a part of the light emitted by said image and to increase its luminosity seen by the observer through the transparent areas, in such a way as to compensate for the shading effect caused by the photovoltaic cells.

2. Device according to Claim 1, **characterized in that** the photovoltaic sheet (5) is arranged at a non-zero distance above the surface of the image (1).

3. Device according to Claim 1, **characterized in that** said sides (3) of the photovoltaic cells (4) turned toward the image are suitable for reflecting more than 30% of the light which they receive.

4. Device according to any one of the preceding claims, **characterized in that** said sides (3) of the photovoltaic cells (4) turned toward the image are white in color or have a metallic appearance.

5. Device according to any one of the preceding claims, **characterized in that** the photovoltaic sheet (5) is fine and/or flexible.

6. Device according to any one of the preceding claims, **characterized in that** the photovoltaic sheet (5) is made from crystalline glass or organic glass.

7. Device according to any one of the preceding claims, **characterized in that** the photovoltaic cells (4) are made from crystalline and/or amorphous or organic silicon or are made up of a plurality of thin photovoltaic layers.

8. Device according to any one of the preceding claims, **characterized in that** the photovoltaic cells (4) form a network of strips parallel to one another and separated by transparent strips.

9. Device according to any one of the preceding claims, **characterized in that** the photovoltaic cells (4) are separated from the image (1) or from the object by a space (2) made up of a transparent material of which the refractive index is greater than 1.

10. Device according to any one of the preceding claims, **characterized in that** it comprises means for modifying the luminosity of the image and/or the contrast of the image and/or the color saturation of the image (1) in such a way as to visually compensate for the degradation of the image due to the superposition of the photovoltaic sheet (5) above the image.

11. Device according to Claim 10, **characterized in that** said means for modifying the luminosity of the image are adjusted in order to increase the luminosity of the image by a percentage equal to or greater than the percentage of cover of the photovoltaic cells (4) on the sheet (5).
